# EUROPÄISCHE PATENTSCHRIFT

(11) **EP 1 528 607 B1**
(45) Veröffentlichungstag und Bekanntmachung des Hinweises auf die Patenterteilung: **10.12.2008**
(21) Anmeldenummer: 04105087.3
(22) Anmeldetag: 15.10.2004
(51) Int. Cl.: H01L 41/053

(54) **Aktormodul**
Actuator module
Module actionneur

(30) Priorität: 27.10.2003 DE 10350062
(43) Veröffentlichungstag der Anmeldung: 04.05.2005
(73) Patentinhaber: ROBERT BOSCH GMBH, 70442 Stuttgart (DE)
(72) Erfinder: Strauss, Bernd, 96149 Breitenguessbach (DE); Schmieder, Dietmar, 71706 Markgroeningen (DE); Kegel, Timo, 71638 Ludwigsburg (DE); Land, Peter, 96175 Pettstadt (DE); Leitner, Christian, 97483 Eltmann (DE); Kraus, Juergen, 96175 Pettstadt (DE)
(74) Vertreter: Körfer, Thomas

(56) Entgegenhaltungen:
- WO-A-01/91197
- DE-A1- 3 244 526
- DE-A1- 10 035 168
- DE-A1- 10 162 045
- DE-A1- 19 719 364
- DE-A1- 19 818 068

## Beschreibung

### Stand der Technik

Die Erfindung geht aus von einem piezoelektrischen oder magnetostriktiven Aktormodul nach der Gattung des Anspruchs 1.

Beispielsweise ist aus der DE 198 56 186 A1 ein piezoelektrischer Aktor bekannt, welcher insbesondere zur Betätigung von Steuerventilen oder Einspritzventilen an Verbrennungsmotoren in Kraftfahrzeugen dient, wobei der Aktor einen piezoelektrischen Aktorkörper, insbesondere in Form eines vielschichtigen Laminats aus aufeinandergeschichteten Lagen piezoelektrischen Materials und dazwischenliegenden metallischen bzw. elektrisch leitenden Schichten, aufweist. Eine der Stirnseiten des Aktorkörpers ist an einem Aktorfuß festgelegt. Der Aktorkörper ist unter Einhaltung eines Zwischenraums von einer Modulwand umgeben, wobei der Zwischenraum mit einem elastischen oder plastischen, elektrisch isolierenden Stoff guter Wärmeleitfähigkeit ausgefüllt ist.

Nachteilig an dem aus der DE 198 56 186 A1 bekannten Aktor sind insbesondere die hohen Fertigungskosten und der hohe Fertigungsaufwand. Diese sind dadurch bedingt, daß der Aktor mittels eines Federbandes vorgespannt wird und die Aktorumspritzung deshalb mit einem relativ dünnflüssigen Material erfolgen muss, um das Aktormodul zum einen allseits ohne Hohlräume umgeben zu können und zum anderen die Elastizität zu erhalten. Die Anforderungen an das Umspritzungsmaterial sind daher sehr hoch, wodurch das Material teuer wird.

In DE 198 18 068 A1 wird ein piezoelektronischer Aktor für einen Stellantrieb beschrieben, der in einem Antriebsgehäuse eingebracht ist, wobei der Aktor einen Aktorstapel aufweist, der von einem hohlzylindrischen Federelement und einem darin angeordneten Aktormantel umfasst ist; das Federelement ist zusammen mit dem Aktorstapel zwischen einem Aktordeckel und einem Aktorboden eingespannt; eine elastische Masse füllt die Spalten zwischen dem Aktorgehäuse, dem Federelement und dem Aktormantel aus. Die elastische Masse ist elektrisch isolierend, elastisch, temperaturbeständig und resistent gegenüber Kraftstoffen. Weiterhin dämpft die elastische Masse die Bewegung zwischen dem Federelement und dem Aktormantel, wobei die Bewegung verstärkt gedämpft wird, wenn zwischen dem Aktorstapel und dem Aktormantel ein schmaler Spalt ausgebildet ist, in dem die elastische Masse eingebracht ist. Dabei ist die Dämpfung z. B. über die Länge des Spalts oder über den Füllgrad des Spaltes mit elastischer Masse einstellbar.

WO 01/91197 A1 offenbart einen Piezoaktor, bei dem ein Piezoelement zur Beaufschlagung eines Betätigungselements mit einer Zug- oder Druckkraft vorgesehen ist. An einem Fußteil, an dem das Piezoelement befestigt ist und über das das Piezoelement unter einer mechanischen Vorspannung in einem Gehäuse zentriert gehalten ist, ist eine Hülse befestigt, die das Piezoelement zumindest in Teilbereichen, elektrisch von diesem isoliert, mechanisch stabilisierend umschließt. Zusätzlich kann ein Hohlprofil aufweisender Zentrierring verwendet werden, der so ausgeführt sind, dass er ein Luftvolumen einschließt und bei Wärmeänderungen zusammendrückbar ist.

DE 101 62 045 A1 offenbart eine Vorrichtung zum Übersetzen einer Auslenkung eines Aktors, insbesondere für ein Einspritzventil. Die Vorrichtung weist im Wesentlichen zwei gegeneinander verschiebbare Kolben auf, die über eine Übertragerkammer miteinander spielfrei gekoppelt sind. Einer der zwei Kolben ist über eine extern angeordnete Feder in eine Ausgangsposition vorgespannt. Durch die Anordnung der Feder außerhalb der Kolben ist eine Reduzierung des Totvolumens zwischen den Kolben möglich und die Funktionsweise der Übertragervorrichtung wird verbessert.

### Vorteile der Erfindung

Das erfindungsgemäß ausgestaltete Aktormodul mit den Merkmalen des Hauptanspruchs hat demgegenüber den Vorteil, dass der Aktor direkt mit dem Aktorgehäuse vergossen wird. Der Verguss weist eine hohe Wärmeleitfähigkeit auf, die die thermische Anbindung des Aktormoduls an das Aktorgehäuse gewährleistet. Eine mehrschichtige Umspritzung ist nicht nötig. Ein solches Aktormodul ist einfach und kostengünstig mit geringem Aufwand herstellbar.

Durch die in den Unteransprüchen aufgeführten Maßnahmen sind vorteilhafte Weiterbildungen und Verbesserungen des im Anspruch 1 angegebenen Aktors möglich.

Vorteilhafterweise wird das Aktormodul vormontiert und dann durch zumindest eine Bohrung im Aktorfuß in einem Arbeitsgang mit dem Verguss verfüllt.

Zudem ist es vorteilhaft, wenn die zumindest eine Bohrung in einfacher Weise nach der Verfüllung mit einer eingepressten Kugel verschließbar ist.

### Zeichnung

Ein Ausführungsbeispiel der Erfindung ist in der Zeichnung vereinfacht dargestellt und in der nachfolgenden Beschreibung näher erläutert. Es zeigen:
- Fig. 1: eine schematische geschnittene Ansicht eines in einem Brennstoffeinspritzventil angeordneten piezoelektrischen Aktormoduls gemäß dem Stand der Technik, und
- Fig. 2: eine schematische geschnittene Ansicht eines in einem Brennstoffeinspritzventil angeordneten erfindungsgemäß ausgestalteten piezoelektrischen Aktormoduls.

### Beschreibung des Ausführungsbeispiels

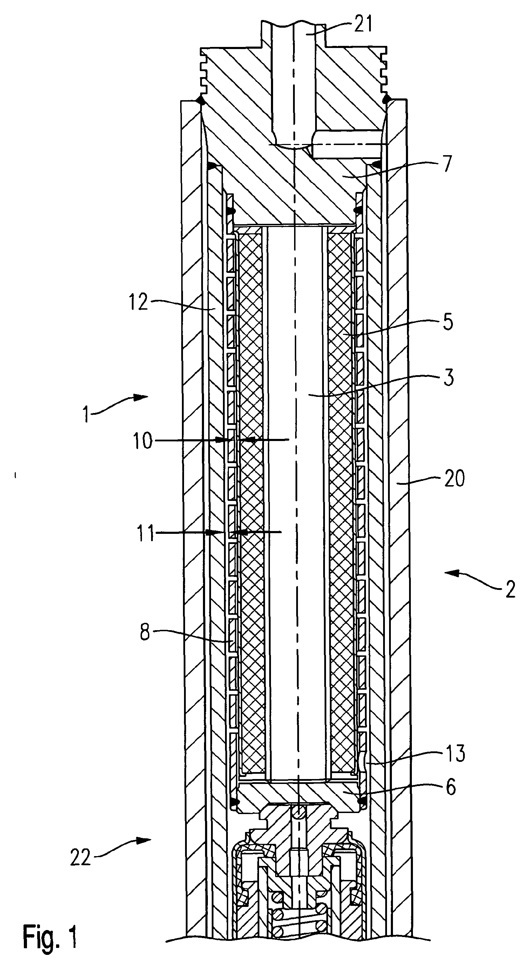

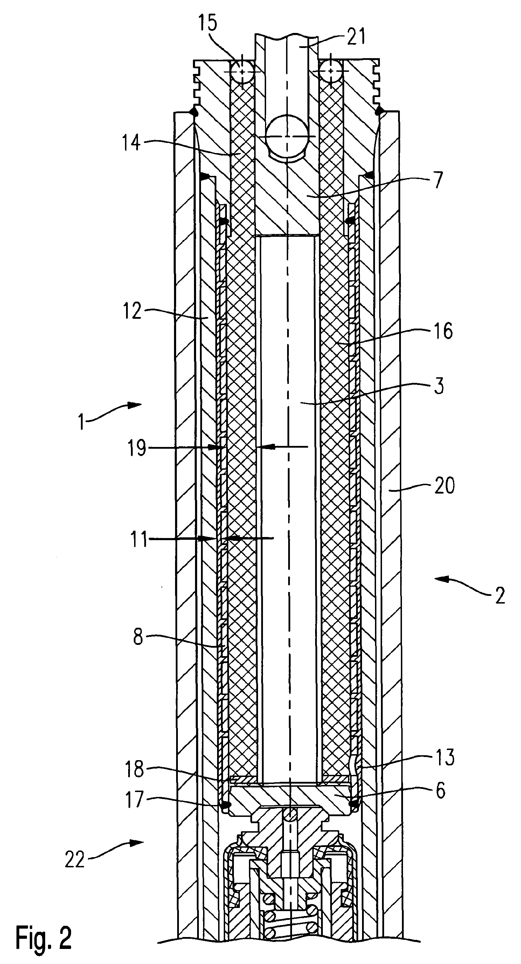

In Fig. 1 ist zur besseren Verständlichkeit der in Fig. 2 dargestellten erfindungsgemäßen Maßnahmen ein Aktormodul 2 gemäß dem Stand der Technik dargestellt. Das in Fig. 1 dargestellte Aktormodul 2 dient z. B. zur Betätigung eines Brennstoffeinspritzventils 1, welches insbesondere zur direkten Einspritzung von Brennstoff in den Brennraum einer gemischverdichtenden, selbst- oder fremdgezündeten Brennkraftmaschine geeignet ist. Das Aktormodul 2 ist in Fig. 1 zur besseren Verständlichkeit der erfindungsgemäßen Maßnahmen in einem Brennstoffeinspritzventil 1 eingebaut dargestellt.

Das Brennstoffeinspritzventil 1 umfaßt ein Ventilgehäuse 20, durch welches Brennstoff durch eine zentrale Brennstoffzufuhr 21 zugeleitet und in Richtung auf einen nicht weiter dargestellten Dichtsitz geführt wird. Das Brennstoffeinspritzventil 1 kann dabei in beliebiger Weise ausgeführt sein. Abströmseitig des Aktormoduls 2 kann ein nicht näher beschriebener hydraulischer Koppler 22 zur Hubübersetzung des Aktormoduls 2 angeordnet sein.

Das Aktormodul 2 besteht aus einem piezoelektrischen oder magnetostriktiven Element 3. Dieses kann sowohl monolithisch ausgeführt sein als auch aus scheibenförmigen piezoelektrischen oder magnetostriktiven Schichten bestehen, welche untereinander verklebt sein können.

Das Aktormodul 2 ist mit in Fig. 1 nicht sichtbaren Kontaktstiften zur Kontaktierung versehen. Die Kontaktstifte und das piezoelektrische oder magnetostriktive Element 3 sind von einer Umspritzung 5 vorzugsweise aus Kunststoff umgeben, in welche die Kontaktstifte eingebettet sind. Die Umspritzung 5 dient dabei der Wärmeableitung der durch das piezoelektrische oder magnetostriktive Element 3 erzeugten Verlustwärme während des Betriebs.

Das piezoelektrische oder magnetostriktive Element 3 ist vorgespannt und mit einem Aktorkopf 6 und einem Aktorfuß 7 versehen. Die Vorspannung wird durch eine Rohrfeder 8 aufgebracht, welche mit dem Aktorkopf 6 und dem Aktorfuß 7 vorzugsweise verschweißt ist.

Zwischen der Rohrfeder 8 und der Umspritzung 5 ist ein erster, innerer Spalt 10 ausgebildet, welcher die Wärmeableitung aus der Umspritzung 5 verhindert. Ebenso ist zwischen einem Aktorgehäuse 12 und der Rohrfeder 8 ein zweiter, äußerer Spalt 11 ausgebildet, welcher die Wärmeableitung aus der Rohrfeder 8 verhindert.

Um eine weitere kostenintensive Umspritzung zu vermeiden, wird erfindungsgemäß vorgeschlagen, das Aktormodul 2 mit einem einzigen Verguß 16 zu versehen, welcher das piezoelektrische oder magnetostriktive Element 3 umhüllt, die Rohrfeder 8 und das Aktorgehäuse 12 ausfüllt und in einem einzelnen Arbeitsschritt eingebracht werden kann. Dies bewirkt die thermische Anbindung des piezoelektrischen oder magnetostriktiven Elements 3 direkt an das Aktorgehäuse 12. Ein Ausführungsbeispiel eines entsprechend ausgeführten Aktormoduls 2 ist in Fig. 2 in gleicher Darstellung wie in Fig. 1 dargestellt.

Die Einbringung des Vergusses 16 erfolgt dabei über zumindest eine Bohrung 14 im Aktorfuß 7, welche nach der Befüllung durch eine eingepreßte Kugel 15 verschlossen wird. Vorzugsweise sind jedoch mehrere Bohrungen 14 vorgesehen, wodurch sichergestellt wird, daß der Verguß 16 gleichmäßig eindringt und auch den Spalt 11 zuverlässig verfüllt.

Der Verguß 16 füllt dabei auch das Aktorgehäuse 12 bis zu einer bestimmten axialen Länge vollkommen aus. Der Verguß 16 kann beispielsweise bis zu einer Schweißnaht 17, welche die Rohrfeder 8 am Aktorkopf 6 fixiert, reichen.

Ein Verfahren zur Montage eines erfindungsgemäß ausgestalteten Aktormoduls 2 läuft dabei in folgenden Schritten ab:

Zunächst wird die Rohrfeder 8 mit dem Aktorfuß 7 verschweißt. Das piezoelektrische oder magnetostriktive Element 3 wird in die Rohrfeder 8 eingelegt. Durch Aufsetzen eines geeignet dimensionierten Rings 18 kann das piezoelektrische oder magnetostriktive Element 3 in der Rohrfeder 8 zentriert und gleichzeitig vor Beschädigungen bei der Montage geschützt werden. Weiterhin wird durch den Ring 18 verhindert, daß das piezoelektrische oder magnetostriktive Element 3 bei der Einbringung des Vergusses 16 aus seiner zentralen Lage verrückt wird.

Ein ähnlicher, in Fig. 2 nicht weiter dargestellter Ring ist am Aktorfuß 7 vorgesehen. Dieser benötigt Ausnehmungen, die deckungsgleich mit den Bohrungen 14 sind, um die Befüllung des Aktormoduls 2 nicht zu behindern. Ist der Aktorkopf 6 auf den Ring 18 aufgesetzt, wird er ebenfalls mit der Rohrfeder 8 verschweißt.

Schließlich wird das vormontierte, nicht umspritzte Aktormodul 2 in das Aktorgehäuse 12 eingeschoben. Nach der Verschweißung des Aktorfußes 7 mit dem Aktorgehäuse 12 wird das Aktorgehäuse 12 sowie der Spalt 11 und ein Zwischenraum 19 zwischen dem piezoelektrischen oder magnetostriktiven Element 3 und der Rohrfeder 8 mit dem Verguß 16 versehen. Das fertig vergossene Aktormodul kann dann mit dem hydraulischen Koppler 22 in dem Ventilgehäuse 20 des Brennstoffeinspritzventils 1 verbaut werden.

Die Erfindung ist nicht auf das dargestellte Ausführungsbeispiel beschränkt und insbesondere bei einer Vielzahl von Bauweisen von Brennstoffeinspritzventilen anwendbar. Auch sind alle Merkmale des Ausführungsbeispiels beliebig miteinander kombinierbar.

## Patentansprüche

1. Aktormodul (2), insbesondere zur Betätigung von Brennstoffeinspritzventilen (1) für Brennstoffeinspritzanlagen von Brennkraftmaschinen, mit zumindest einem piezoelektrischen oder magnetostriktiven Element (3), wobei das Aktormodul (2) durch eine Rohrfeder (8) vorgespannt und in einem Aktorgehäuse (12) gekapselt ist,
**dadurch gekennzeichnet,**
**dass** das Aktorgehäuse (12) mit einem einzigen Verguss (16) zur thermischen Anbindung des piezoelektrischen oder magnetostriktiven Elements (3) direkt an das Aktorgehäuse (12) verfüllt ist, welcher einen Zwischenraum (19) zwischen dem piezoelektrischen oder magnetostriktiven Element (3) und der Rohrfeder (8) sowie einen Spalt (11) zwischen der Rohrfeder (8) und dem Aktorgehäuse (12) ausfüllt,
wobei der Verguss (16) durch zumindest eine Bohrung (14) in einem Aktorfuß (7) in das Aktorgehäuse (12) einbringbar ist, und
wobei an einem Aktorkopf (6) ein Ring (18) vorgesehen ist, der von dem piezoelektrischen oder magnetostriktiven Element (3) durchgriffen ist, und an dem Aktorfuß (7) ebenfalls ein Ring vorgesehen ist, welcher Ausnehmungen aufweist, die deckungsgleich mit der zumindest einen Bohrung (14) sind.

2. Aktormodul nach Anspruch 1,
**dadurch gekennzeichnet,**
**dass** die zumindest eine Bohrung (14) durch eine eingepresste Kugel (15) verschlossen ist.

3. Aktormodul nach einem der Ansprüche 1 oder 2,
**dadurch gekennzeichnet,**
**dass** das Aktormodul (2) über den Verguss (16) thermisch an das Aktorgehäuse (12) gekoppelt ist.

4. Aktormodul nach einem der Ansprüche 1 bis 3,
**dadurch gekennzeichnet,**
**dass** sich der Verguss (16) über die axiale Gesamtlänge des Aktormoduls (2) erstreckt.

## Claims

1. Actuator module (2), in particular for actuating fuel injection valves (1) for fuel injection systems of internal combustion engines, having at least one piezoelectric or magnetostrictive element (3), with the actuator module (2) being preloaded by means of a tubular spring (8) and being encapsulated in an actuator housing (12),
**characterized**
**in that** the actuator housing (12) is filled with a single sealing compound (16) for thermally connecting the piezoelectric or magnetostrictive element (3) directly to the actuator housing (12), which sealing compound (16) fills an intermediate space (19) between the piezoelectric or magnetostrictive element (3) and the tubular spring (8) and also a gap (11) between the tubular spring (8) and the actuator housing (12),
with it being possible for the sealing compound (16) to be introduced into the actuator housing (12) through at least one bore (14) in an actuator foot (7), and
with a ring (18) being provided on an actuator head (6), through which ring (18) the piezoelectric or magnetostrictive element (3) extends, and with a ring likewise being provided on the actuator foot (7), which ring has recesses which are arranged congruently with the at least one bore (14).

2. Actuator module according to Claim 1,
**characterized**
**in that** the at least one bore (14) is closed off by means of a pressed-in ball (15).

3. Actuator module according to one of Claims 1 or 2,
**characterized**
**in that** the actuator module (2) is thermally coupled to the actuator housing (12) by means of the sealing compound (16).

4. Actuator module according to one of Claims 1 to 3,
**characterized**
**in that** the sealing compound (16) extends over the entire axial length of the actuator module (2).

## Revendications

1. Module d'actionneur (2) notamment pour actionner des injecteurs de carburant (1) destinés à des installations d'injection de carburant équipant des moteurs à combustion interne comprenant au moins un élément piézo-électrique ou magnétostrictif (3),
le module d'actionneur (2) étant précontraint par un ressort tubulaire (8) et encapsulé dans un boîtier d'actionneur (12),
**caractérisé en ce que**
le boîtier d'actionneur (12) est rempli d'une unique matière coulée (16) pour coupler de manière thermique l'élément piézo-électrique ou magnétostrictif (3) directement au boîtier d'actionneur (12), cette matière coulée remplissant l'espace intermédiaire (19) entre l'élément piézo-électrique ou magnétostrictif (3) et le ressort tubulaire (8) ainsi qu'un intervalle (11) entre le ressort tubulaire (8) et le boîtier d'actionneur (12),
la matière coulée (16) étant introduite dans le boîtier d'actionneur (12) à travers au moins un perçage (14) réalisé dans le pied (7) de l'actionneur, et
la tête (6) de l'actionneur comporte une bague (18) traversée par l'élément piézo-électrique ou magnétostrictif (3), et le pied (7) de l'actionneur comporte également une bague munie de dégagements qui coïncident au moins avec un perçage (14).

2. Module d'actionneur selon la revendication 1,
**caractérisé en ce qu'**
au moins le perçage (14) est fermé par une bille (15) enfoncée de force.

3. Module d'actionneur selon la revendication 1 ou 2,
**caractérisé en ce que**
le module d'actionneur (2) est couplé thermiquement au boîtier d'actionneur (12) par l'intermédiaire de la matière coulée (16).

4. Module d'actionneur selon les revendications 1 à 3,
**caractérisé en ce que**
la matière coulée (16) occupe toute la longueur axiale du module d'actionneur (2).
